# EUROPEAN PATENT APPLICATION

(11) **EP 4 403 437 A1**
(43) Date of publication of application: **24.07.2024**
(21) Application number: 21957434.0
(22) Date of filing: 14.09.2021
(51) Int. Cl.: B61L 99/00, G01R 31/50

(54) **LIGHTNING ARRESTER MONITORING DEVICE AND RAILWAY VEHICLE PROVIDED WITH SAME**

(71) Applicant: Kawasaki Railcar Manufacturing Co., Ltd., Kobe-shi, Hyogo 652-0884 (JP)
(72) Inventor: TAKAHASHI, Keisuke, Kobe-shi, Hyogo 652-0884 (JP); TATEISHI, Go, Kobe-shi, Hyogo 652-0884 (JP); OTA, Masato, Kobe-shi, Hyogo 652-0884 (JP)
(74) Representative: Witte, Weller & Partner Patentanwälte mbB
(86) International application number: PCT/JP2021/033698
(87) International publication number: WO 2023/042250

(57) **Abstract**

The present disclosure includes: a galvanometer (21) that measures, on an electrical path (18) between an arrester (16) of a railcar and a carbody (19) of the railcar, a value of a current that flows from the arrester (16) to the carbody (19); a data storage (22) that stores the value of the current, which has been measured by the galvanometer (21), as history data in a chronological manner; and processing circuitry (23) configured to determine, based on a chronological change in the history data stored in the data storage (22), that the arrester (16) is in a state of deterioration and output a predetermined deterioration signal in a case where an average value of the current within a predetermined unit time is greater than a predetermined deterioration threshold value. With this configuration, deterioration of the arrester (16) included in the railcar is monitored.

## Description

### Technical Field

The present disclosure relates to an arrester monitor and a railcar including the same.

### Background Art

Conventionally, a railcar includes an arrester. When a large current flows from an overhead contact line, the arrester diverts the large current such that it flows from the carbody to the rails, thereby preventing the large current from flowing through main circuitry. When the large current flows through an electrical path of the arrester, the internal resistance value thereof drops temporarily to divert the large current to the carbody. The large current is caused by lightning or by a surge that occurs when raising/lowering the pantograph. The arrester protects devices that are connected to the main circuitry from the large current. Usually, the arrester is replaced at each specified period.

One example of conventional art relating to this type of arrester is an arrester leakage current detector that is installed at, for example, a transformer substation (see Patent Literature 1, for example). The arrester leakage current detector includes a total leakage current measurer and a total leakage current storage. The arrester leakage current detector further includes: a higher harmonic remover to remove higher harmonics in a total leakage current; a total leakage current waveform adjuster; a total leakage current difference detector; and a resistance component current detector to detect a resistance component current in the total leakage current. With this configuration, the resistance component current of the arrester is obtained, and based on the obtained resistance component current, deterioration of the arrester is detected at an early stage.

### Citation List

### Patent Literature

PTL 1: Japanese Patent No. 6616193

### Summary of Invention

### Technical Problem

As described above, the arrester included in the railcar diverts the large current to the carbody to prevent the large current from flowing through the main circuitry. However, there is a case where the arrester deteriorates more than expected even within the aforementioned specified period. If the arrester deteriorates, the leakage current that flows from the arrester to the carbody increases, and consequently, the amount of electric power transmitted to the main circuitry decreases.

The above-described conventional art relates to an arrester installed at a transformer substation or the like, and monitors deterioration of the arrester by measuring the total leakage current of the arrester at a predetermined time. Therefore, this conventional art is not applicable to monitoring the deterioration of an arrester included in a railcar that is operated at different times in accordance with an operation schedule or the like.

In view of the above, an object of one aspect of the present disclosure is to provide an arrester monitor that is capable of monitoring deterioration of an arrester included in a railcar based on the value of a current that flows from the arrester to a carbody of the railcar, and to provide a railcar including the arrester monitor.

### Solution to Problem

In order to achieve the above object, an arrester monitor according to one aspect of the present disclosure includes: a galvanometer that measures, on an electrical path between an arrester of a railcar and a carbody of the railcar, a value of a current that flows from the arrester to a grounded part the carbody; a data storage that stores the value of the current, which has been measured by the galvanometer, as history data in a chronological manner; and processing circuitry configured to determine, based on a chronological change in the history data stored in the data storage, that the arrester is in a state of deterioration and output a predetermined deterioration signal in a case where an average value of the current within a predetermined unit time is greater than a predetermined deterioration threshold value.

### Advantageous Effects of Invention

One aspect of the present disclosure makes it possible to provide an arrester monitor capable of monitoring deterioration of an arrester included in a railcar based on the value of a current that flows from the arrester to a carbody of the railcar.

### Brief Description of Drawings

FIG. 1 is a side view schematically showing a railcar according to one embodiment of the present disclosure.
FIG. 2 is an overall view of an arrester monitor included in the railcar shown in FIG. 1.
FIG. 3 is a block diagram including a configuration of the arrester monitor shown in FIG. 2.
FIG. 4 is a graph showing current/voltage changes when the value of a current measured by a galvanometer of the arrester monitor of FIG. 3, the current flowing from an arrester to a carbody, is in a normal state, the graph also showing the current/voltage changes when the arrester is in a state of failure.
FIG. 5 is a graph chronologically showing a first measurement example of measuring current values by the galvanometer shown in FIG. 3.
FIG. 6 is a graph chronologically showing a second measurement example of measuring current values by the galvanometer shown in FIG. 3.
FIG. 7 is a graph showing, as an average value within a unit time, the current values measured in the second measurement example of FIG. 6.
FIG. 8 is a graph showing one example where the deterioration level of the arrester is divided by multiple deterioration threshold values.
FIG. 9 is a graph showing one example of setting multiple deterioration levels based on current values in relation to the current/voltage changes shown in FIG. 4.
FIG. 10 is a first flowchart showing a flow of operations of the arrester monitor while the railcar is operating.
FIG. 11 is a second flowchart showing a flow of operations of the arrester monitor at the time of powering on the railcar.
FIG. 12 is a third flowchart showing a flow of operations of the arrester monitor at the time of powering off the railcar.
FIG. 13 illustrates a display example of "WARNING" on a display monitor screen as shown in FIG. 10 and FIG. 11.
FIG. 14 illustrates a display example of "FAILURE" on the display monitor screen as shown in FIG. 10 and FIG. 11.

### Description of Embodiments

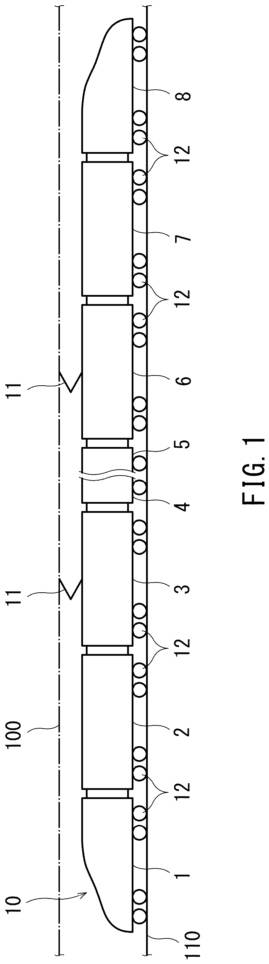

Hereinafter, one embodiment of the present disclosure is described. The embodiment described below is merely one example, in which the description is given by taking a high-speed railcar that travels at a relatively high speed as an example. The forward-backward direction referred to in the description and the claims coincides with a traveling direction of a railcar 10 shown in FIG. 1, which is a side view of the railcar 10.

### (Configuration of Railcar)

FIG. 1 is a side view schematically showing the railcar 10 according to one embodiment. The railcar 10 in this embodiment includes eight cars as one example. The railcar 10 is a train set in which cars 1 to 8 are coupled to one another. In this example, a pantograph 11 is located on the roof of each of the car 3 and the car 6 of the railcar 10. The pantograph 11 is in contact with an overhead contact line 100 with a constant pressure. The railcar 10 travels on rails 110 by wheels 12. The present embodiment describes the railcar 10 including eight cars as one example. However, the number of cars included in the railcar 10, the arrangement of the pantographs on the railcar 10, etc., are not limited to those described in this example.

### (Configuration of an arrester monitor)

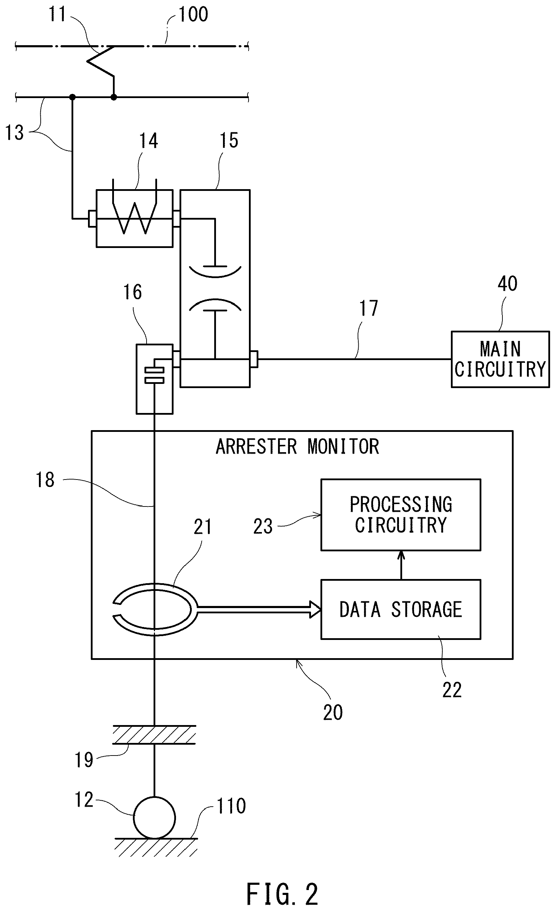

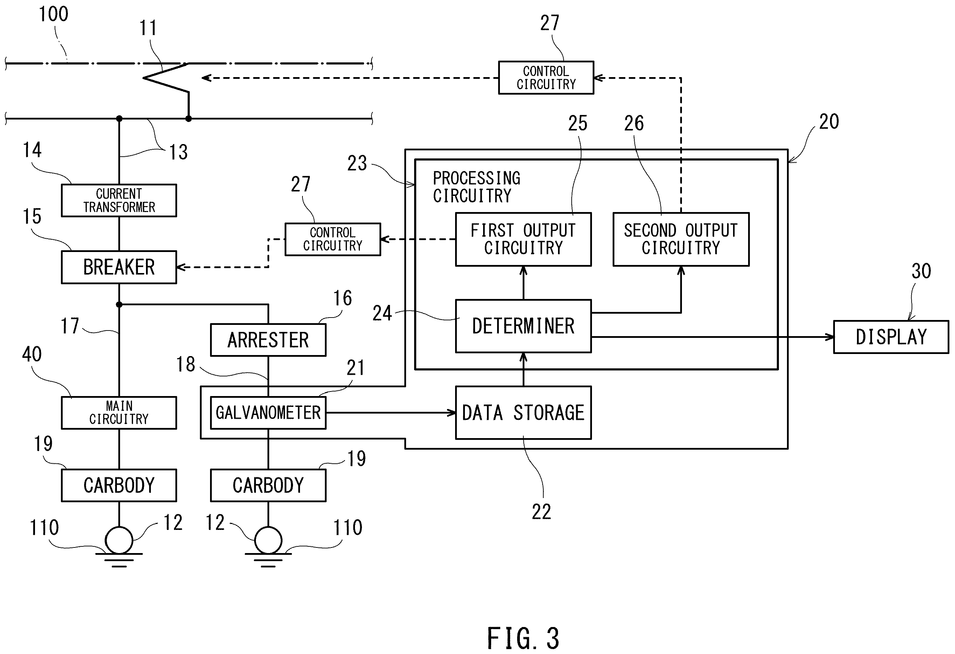

FIG. 2 is an overall view of an arrester monitor 20 included in the railcar 10 shown in FIG. 1. FIG. 3 is a block diagram including a configuration of the arrester monitor 20 shown in FIG. 2.

As shown in FIG. 2, in the present embodiment, a large current that flows from the overhead contact line 100 to a power feeding path 13 via the pantograph 11 is transformed into a small current by a current transformer (CT) 14. A breaker 15, which blocks between the current transformer 14 and main circuitry 40 (e.g., VCB: Vacuum Circuit Breaker), is located downstream of the current transformer 14. An arrester 16 is located between the breaker 15 and the main circuitry 40. When a temporarily large current such as a lightning current or surge current occurs, the arrester 16 causes the temporary large current to flow through a carbody 19. Through the carbody 19, the current is diverted to the rails 110. The main circuitry 40 is located downstream of the arrester 16 via a main circuitry electrical path 17. According to the railcar 10 of the present embodiment, the current from the pantograph 11 flows to the arrester 16 and the main circuitry 40 via the current transformer 14 and the breaker 15. In a case where the voltage value of the current that flows from the breaker 15 to the main circuitry 40 exceeds a threshold value, the arrester 16 diverts the current such that it flows from the carbody 19 to the rails 110 via an electrical path 18, thereby protecting the main circuitry 40. A current transformer, a breaker, and an arrester that are suitable for the railcar 10 may be used as the current transformer 14, the breaker 15, and the arrester 16.

The railcar 10 of the present embodiment includes the arrester monitor 20, which is located on the electrical path 18 between the arrester 16 and the carbody 19 and which includes a galvanometer 21. The galvanometer 21 measures the value of a current that flows from the arrester 16 to the carbody 19 via the electrical path 18. The galvanometer 21 may be, for example, a moving-coil galvanometer. Examples of a current that flows through the electrical path 18 include: a leakage current that flows from the arrester 16 to the carbody 19; a temporary large lightning current; and a surge current that flows at the time of connecting the pantograph 11. The galvanometer 21 is electrically connected to a data storage 22 of the arrester monitor 20. The value of the current measured by the galvanometer 21 is stored in the data storage 22 in a chronological manner. The data storage 22 may be integrated with processing circuitry 23. The data storage 22 may include an internal storage medium such as a flash memory or hard disk to store current values measured by the galvanometer 21.

As shown in FIG. 3, the arrester monitor 20 measures, on the electrical path 18 and with the galvanometer 21, a current that flows from the arrester 16 to the carbody 19. The value of the current measured by the galvanometer 21 is transmitted to the data storage 22 and stored therein in a chronological manner. The data storage 22 is electrically connected to the processing circuitry 23. The processing circuitry 23 includes a determiner 24. As described below, based on a result of a determination by the determiner 24, a breaker-opening signal is outputted from first output circuitry 25 to control circuitry 27 of the railcar 10. Further, based on a result of a determination by the determiner 24, a signal to prohibit pantograph raising is outputted from second output circuitry 26 to the control circuitry 27 of the railcar 10.

The processing circuitry 23 includes the determiner 24, an I/O interface, and so forth. The determiner 24 includes a processor, a volatile memory, a nonvolatile memory, and so forth. An input of a signal indicating a current value stored in the data storage 22 to the processing circuitry 23, a signal output from the first output circuitry 25, a signal output from the second output circuitry 26, and a signal output from the determiner 24 to a display 30 are realized by the I/O interface. The determination by the determiner 24 is realized as a result of the processor performing arithmetic processing based on a program stored in the nonvolatile memory by using the volatile memory.

In the present embodiment, as described below, based on a result of a determination by the determiner 24, a control signal to give a command to open the breaker 15 or to give a command to prohibit raising of the pantograph 11 is outputted to the control circuitry 27 of the railcar 10. Also, as described below, based on a result of a determination by the determiner 24, a predetermined deterioration signal is outputted to the display 30, which is, for example, a display monitor of the railcar, to raise an alarm.

### (Examples of current/voltage changes in the arrester)

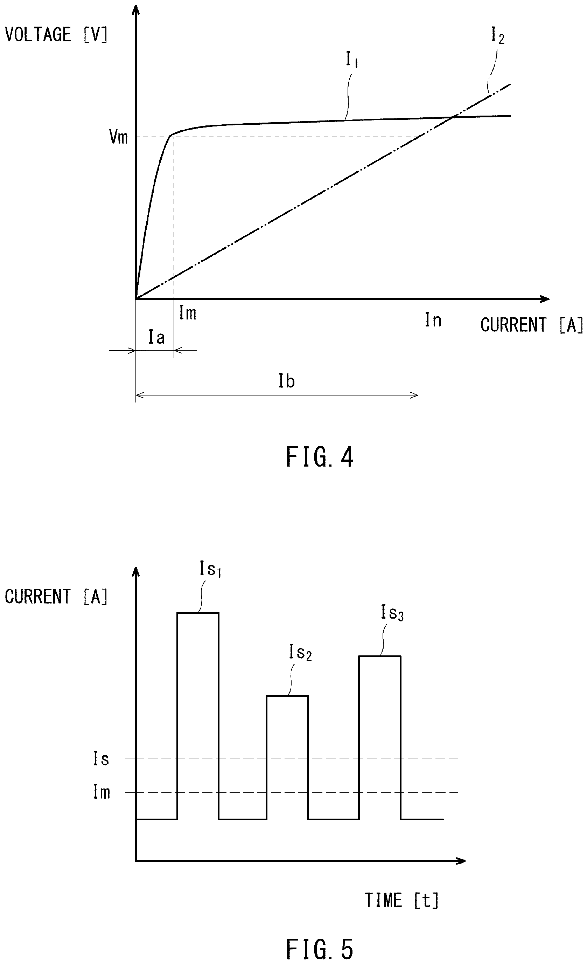

FIG. 4 is a graph showing current/voltage changes when the value of a current measured by the galvanometer 21 of the arrester monitor 20 of FIG. 3, the current flowing from the arrester 16 to the carbody 19, is in a normal state. The graph also shows the current/voltage changes when the arrester 16 is in a state of failure. FIG. 4 is a conceptual diagram showing, for both when the arrester 16 is in a normal state and when the arrester 16 is in a state of failure, changes in a voltage and a current that flow from the arrester 16 to the carbody 19. In FIG. 4, the horizontal axis represents current [A], and the vertical axis represents voltage [V].

A slight leakage current occurs in the arrester 16 even when the arrester 16 is in a normal state. A leakage current I₁ of the arrester 16 increases little by little until an operation start voltage Vm of the arrester 16 is reached. When the operation start voltage Vm of the arrester 16 is reached, a large amount of current flows from the arrester 16 to the carbody 19, and as a result, the current value increases significantly. The current value at the operation start voltage Vm is an operation start current Im. Thus, even when the arrester 16 is in a normal state, the leakage current I₁ occurs, and the leakage current I₁ increases little by little until the operation start current Im is reached, but after the operation start current Im is exceeded, the leakage current I₁ increases significantly.

On the other hand, in a case where the arrester 16 is in a state of failure, a leakage current I₂ of the arrester 16 increases in proportional to an increase in the voltage. The leakage current I₂ increases linearly to a leakage current value In, at which the operation start voltage Vm is reached. Accordingly, in a case where a failure occurs in the arrester 16, the leakage current of the arrester 16 changes from a normal-state leakage current Ia into a failure-state leakage current Ib, i.e., increases very significantly, and as a result, the main circuitry 40 is not sufficiently fed with electric power.

### (Examples of changes in the value of a current that flows through an electrical path)

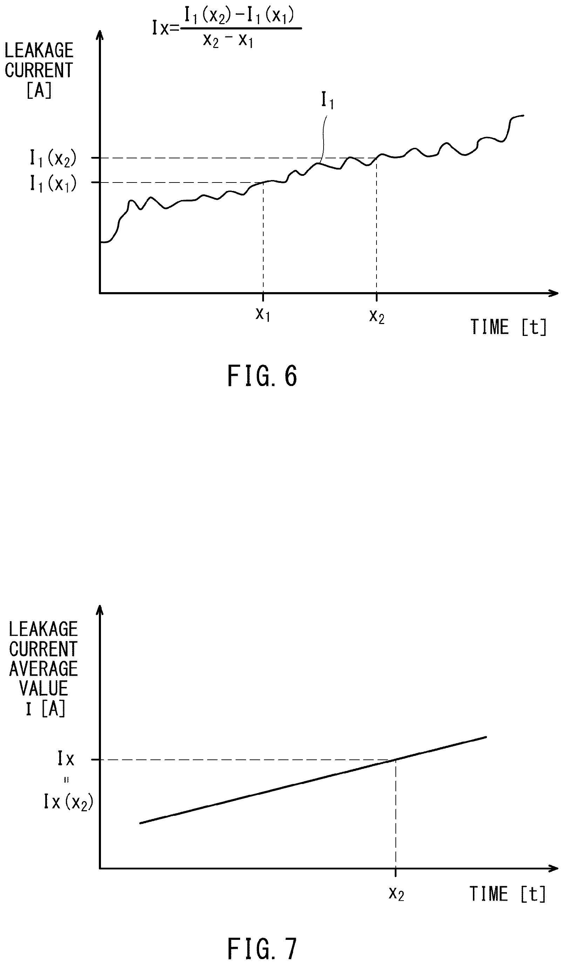

FIG. 5 is a graph chronologically showing a first measurement example of measuring current values by the galvanometer 21 shown in FIG. 3. In FIG. 5, the horizontal axis represents time [t], and the vertical axis represents current [A]. FIG. 6 is a graph chronologically showing a second measurement example of measuring current values by the galvanometer 21 shown in FIG. 3. In FIG. 6, the horizontal axis represents time [t], and the vertical axis represents leakage current [A]. FIG. 7 is a graph showing, as an average value within a unit time, the current values measured in the second measurement example of FIG. 6. In FIG. 7, the horizontal axis represents time [t], and the vertical axis represents leakage current average value I [A].

The first measurement example of FIG. 5 schematically shows an example in which a large lightning current or a surge current at pantograph raising flows through the carbody 19 via the arrester 16. An overcurrent threshold value Is is preset for a large current that flows from the arrester 16 to the carbody 19, and is stored in the processing circuitry 23. The overcurrent threshold value Is is greater than the operation start current Im of the arrester 16, and is set to the value of an overcurrent that affects the life of the arrester 16. The example in FIG. 5 shows a record of three times occurrence (Is₁, Is₂, Is₃) of a current value change pattern in which the current value measured by the galvanometer 21 exceeds the predetermined overcurrent threshold value Is and then drops below the overcurrent threshold value Is. The processing circuitry 23 determines whether or not the current value change pattern, in which the current value measured by the galvanometer 21 exceeds the overcurrent threshold value Is and then drops below the overcurrent threshold value Is, has occurred more than a predetermined number of times. In a case where a result of the determination indicates that the current value change pattern has occurred more than the predetermined number of times, it is determined that the arrester 16 is in a state of deterioration. The predetermined number of times may be set based on, for example, the size of the arrester 16.

The second measurement example of FIG. 6 schematically shows an example in which due to aging deterioration of the arrester 16, the leakage current I₁ flowing through the carbody 19 via the arrester 16 increases. The leakage current I₁ in a small amount is flowing from the arrester 16 to the carbody 19. The leakage current I₁ gradually increases due to, for example, deterioration of the arrester 16. FIG. 6 shows an example in which the leakage current I₁ flowing from the arrester 16 to the carbody 19 changes due to operations of the railcar 10, and increases in accordance with elapse of time. Such chronological changes in the leakage current I₁ may be defined as, for example, an average value Ix within a predetermined time from a leakage current I₁(x₁) at a time x₁ to a leakage current I₁(x₂) at a time x₂.

Then, as shown in FIG. 7, the average value Ix of the leakage current I₁ within the predetermined time shown in the graph of FIG. 6 may be defined as a leakage current average value Ix(x₂) at the time x₂. In a case where the leakage current average value Ix(x₂) shown in FIG. 7 is greater than a predetermined deterioration threshold value, it can be determined that the arrester 16 is in a state of deterioration.

Further, as shown in FIG. 7, by defining the average value Ix within the predetermined time shown in FIG. 6 as the value at the time x₂, which is the end of the predetermined time, whether or not the arrester 16 is in a state of deterioration can be determined, the next time the arrester monitor 20 is powered on, based on the average value Ix of the leakage current I₁ at a point immediately before the previous powering off of the arrester monitor 20.

### (One example of division into multiple deterioration levels)

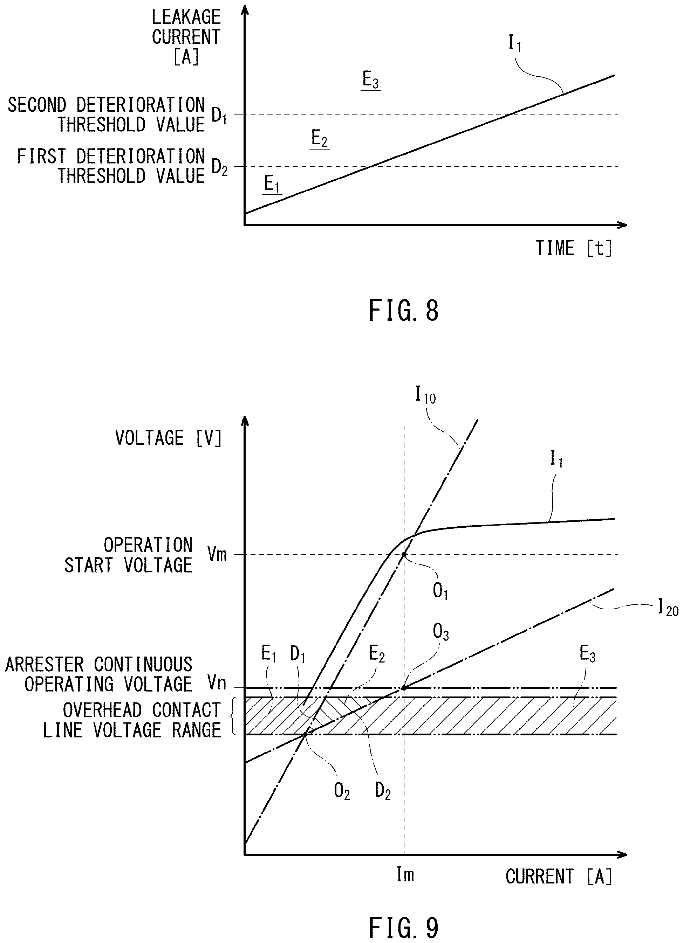

FIG. 8 is a graph showing one example where the deterioration level of the arrester 16 is divided by multiple deterioration threshold values. In FIG. 8, the horizontal axis represents time [t], and the vertical axis represents leakage current [A]. FIG. 8 shows a case where the voltage that changes while the railcar 10 is operating is assumed to be constant. The leakage current I₁ of the arrester 16 increases as the deterioration of the arrester 16 progresses in accordance with elapse of time. When the leakage current I₁, which increases in accordance with a progress in the deterioration of the arrester 16, increases from a normal level E₁ to have exceeded a first deterioration threshold value D₁, it is determined that a first deterioration level E₂ has been reached. When the leakage current I₁ increases from the first deterioration level E₂ to have exceeded a second deterioration threshold value D₂, it is determined that a second deterioration level E₃ has been reached. In the present embodiment, when the first deterioration level E₂ has been reached, a "warning" alarm is raised, and when the second deterioration level E₃ has been reached, a "failure" alarm is raised. The leakage current I₁ shown in FIG. 8 is one example illustrated in relation to the constant voltage, and this example conceptually shows the leakage current I₁, which increases in accordance with a progress in the deterioration of the arrester 16. The leakage current I₁ is not uniform, and is affected by various conditions (e.g., voltage changes, usage time of the arrester, etc.). Therefore, the slope of the leakage current I₁, changes in the leakage current I₁, etc., are not limited to those in the illustrated example.

### (Specific example of division into multiple deterioration levels)

FIG. 9 is a graph showing one example of setting multiple deterioration levels based on current values in relation to the current/voltage changes shown in FIG. 4. In FIG. 9, the horizontal axis represents current [A], and the vertical axis represents voltage value [V]. FIG. 9 shows a part of FIG. 4 in an enlarged manner, such that a part where the deterioration levels are set is illustrated in an exaggerated manner. In this example, multiple deterioration levels of the arrester 16 are set by leakage current values within an overhead contact line voltage range.

As described above, when the arrester 16 is in a normal state, the leakage current I₁ increases little by little in accordance with increase in the voltage, and when the operation start voltage Vm is reached, the leakage current I₁ increases significantly from the operation start current Im. In FIG. 9, a line that indicates changes in the leakage current I₁ until the operation start voltage Vm and the operation start current Im are reached is approximated by a straight line, and the straight line is defined as a first level determination line I₁₀. The first level determination line I₁₀ is shifted in a parallel direction so as to coincide with an intersection point O₁ of the operation start voltage Vm and the operation start current Im. The current value indicated by the first level determination line I₁₀ serves as a deterioration threshold value. In this example, multiple deterioration levels are set, and the current value indicated by the first level determination line I₁₀ is the first deterioration threshold value D₁. Values greater than the first deterioration threshold value D₁ are defined to fall within the first deterioration level E₂. The first level determination line I₁₀ is, for example, a straight line that approximates the leakage current I₁ in a normal state, and the first level determination line I₁₀ is shifted to the operation start current Im at which the current value is higher. The current value indicated by the first deterioration threshold value D₁ is slightly higher than the leakage current I₁ in a normal state. The current value indicated by the first deterioration threshold value D₁ increases in accordance with increase in the voltage. The rate of increase in the first deterioration threshold value D₁ in accordance with increase in the voltage is similar to the rate of increase in the leakage current I₁ in a normal state in accordance with increase in the voltage.

In FIG. 9, a second level determination line I₂₀ is drawn to set another deterioration level. A line that connects between an intersection point Oz and an intersection point O₃ is set as the second level determination line I₂₀. The intersection point Oz is an intersection point of the lower limit of the overhead contact line voltage range and the first level determination line I₁₀. The intersection point O₃ is an intersection point of an arrester continuous operating voltage Vn and the operation start current Im. The overhead contact line voltage range is the voltage range of the overhead contact line, and changes while the railcar 10 is operating. The arrester continuous operating voltage Vn is a voltage that can be continuously applied between both terminals of the arrester 16 (JIS E 5010), and is set in accordance with the arrester 16.

A current value indicated by the second level determination line I₂₀ is the second deterioration threshold value D₂, and values exceeding the second deterioration threshold value D₂ are defined to fall within the second deterioration level E₃. The second deterioration threshold value D₂ is set such that the current value indicated thereby increases in accordance with increase in the voltage. In this example, the rate of increase in the second deterioration threshold value in accordance with increase in the voltage is greater than the rate of increase in the first deterioration threshold value in accordance with increase in the voltage. In FIG. 9, the second deterioration threshold value D₂ at the lower limit of the overhead contact line voltage range is the current value at the intersection point Oz of the first level determination line I₁₀ and the lower limit of the overhead contact line voltage range. Alternatively, the second level determination line I₂₀ may intersect the lower limit of the overhead contact line voltage range at a current value that is less than or greater than the intersection point Oz.

In the present embodiment, in the arrester monitor 20, it is determined whether or not a leakage current value measured by the galvanometer 21 is greater than the first deterioration threshold value D₁ of the first level determination line I₁₀, and it is also determined whether or not the leakage current value measured by the galvanometer 21 is greater than the first deterioration threshold value D₁ of the first level determination line I₁₀ and the second deterioration threshold value D₂ of the second level determination line I₂₀. These determinations are performed within the overhead contact line voltage range. In the present embodiment, based on results of these determinations, one of the following is performed: raising "no alarm"; raising a "warning" alarm; and raising a "failure" alarm.

Based on chronological changes in the leakage current measured by the galvanometer 21, in a case where the leakage current value is within the range of the normal level E₁, which is less than the first deterioration threshold value D₁, it is determined that the leakage current I₁ is within its normal range, and "no alarm" is raised.

Based on chronological changes in the leakage current measured by the galvanometer 21, in a case where the leakage current value is within the range of the first deterioration level E₂, which is greater than the first deterioration threshold value D₁ but less than the second deterioration threshold value D₂, it means that the leakage current I₁ has slightly increased. Therefore, a "warning" alarm is raised.

Based on chronological changes in the leakage current measured by the galvanometer 21, in a case where the leakage current value is within the range of the second deterioration level E₃, which is greater than the second deterioration threshold value D₂, it means that the leakage current I₁ has exceeded the predetermined range. Therefore, a "failure" alarm is raised. In the example shown in FIG. 9, at the lower limit of the overhead contact line voltage range, the next level after the normal level E₁ for which "no alarm" is raised is the second deterioration level E₃ for which a "failure" alarm is raised. However, as mentioned above, the intersection point of the second level determination line I₂₀ and the lower limit of the overhead contact line voltage range may be set to a current value that is greater than the intersection point Oz of the first level determination line I₁₀ and the lower limit of the overhead contact line voltage range, so that the first deterioration level E₂, for which a "warning" alarm is raised, exists at the lower limit of the overhead contact line voltage range. Alternatively, the intersection point of the second level determination line I₂₀ and the lower limit of the overhead contact line voltage range may be set to a current value that is less than the intersection point Oz. This makes it possible to raise a "failure" alarm for a less leakage current.

Thus, the state of deterioration of the arrester 16 is divided into multiple deterioration levels corresponding to respective magnitudes of the leakage current I₁. By the division into the multiple deterioration levels, a deterioration signal can be made different for each deterioration level. Making the deterioration signal different for each deterioration level of the arrester 16 makes it possible to perform, for example, replacement work of the arrester 16 in accordance with a prepared plan.

In the present embodiment, the example has been described, in which the first deterioration threshold value D₁ and the second deterioration threshold value D₂ are set, and based thereon two-stage deterioration level determination is performed, in which the alarms are raised in two stages, i.e., "warning" and "failure", from the state of "no alarm". However, the deterioration level determination may be performed in an alternative manner, in which a "failure" alarm is raised from the state of "no alarm". Further alternatively, more than two deterioration levels may be set.

### (Flowchart during operation of the railcar)

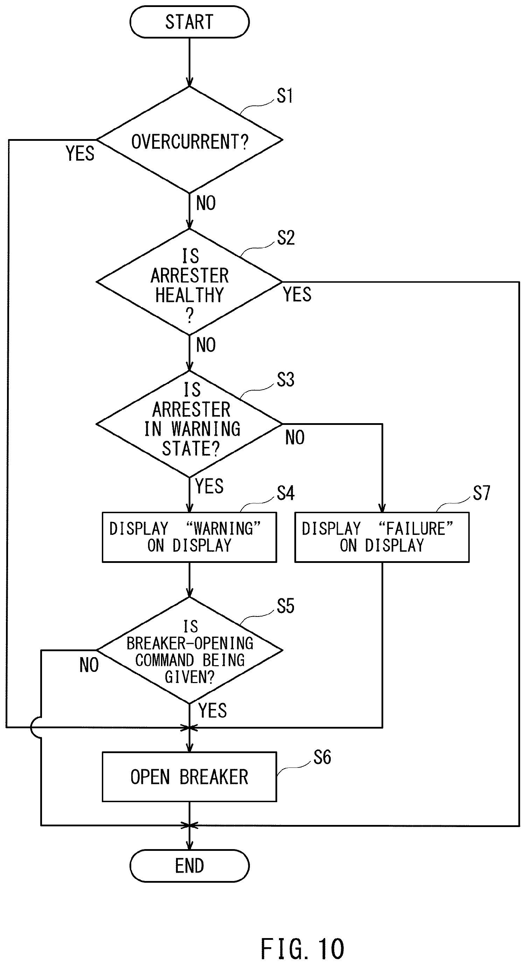

FIG. 10 is a first flowchart showing a flow of operations of the arrester monitor 20 while the railcar 10 is operating. The following description is given by using the reference signs shown in FIG. 3.

After the flow starts, it is determined whether or not a current flowing through the current transformer 14 is an overcurrent (S1). In a case where the current flowing through the current transformer 14 is an overcurrent, the breaker 15 is opened (S6), and the flow ends. In a case where the current flowing through the current transformer 14 is not an overcurrent, it is determined whether or not the arrester 16 is in a healthy state (S2). In a case where the arrester 16 is determined to be in a healthy state, the flow ends. In a case where it is determined in the determination step (S2) that the arrester 16 is not in a healthy state, it is further determined whether or not the arrester 16 is in a warning state (S3). This determination can be made based on, for example, the example shown in FIG. 8, in which the multiple deterioration levels are set. In a case where the arrester 16 is in a warning state, a signal to display "WARNING" is outputted to the display 30 (S4). Thereafter, it is determined whether or not a breaker-opening command is being given (S5). In a case where no breaker-opening command is being given, the flow ends, whereas in a case where a breaker-opening command is being given, the breaker 15 is opened (S6), and the flow ends. In a case where it is determined in the above determination step (S3) that the arrester 16 is not in a warning state, a signal to display "FAILURE" is outputted to the display 30 (S7). In a case where the arrester 16 is in a state of failure, the breaker 15 is opened (S6), and the flow ends.

### (Flowchart at the time of powering on the railcar)

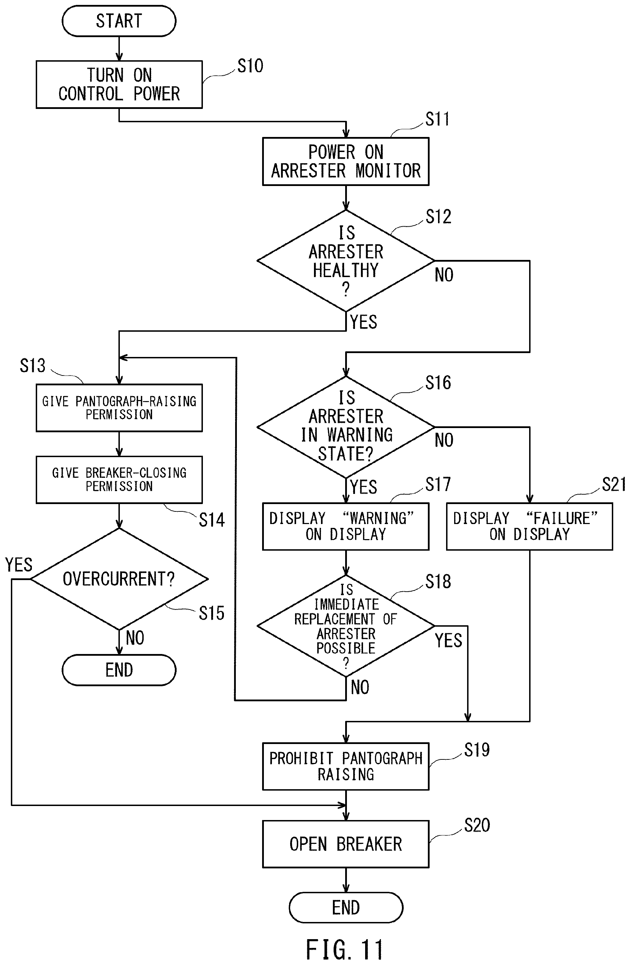

FIG. 11 is a second flowchart showing a flow of operations of the arrester monitor 20 at the time of powering on the railcar 10. In this flowchart, a flow of operations of the railcar 10 is shown on the left side, and the flow of operations of the arrester monitor 20 is shown on the right side. The following description is given by using the reference signs shown in FIG. 3.

After the flow starts, when the control power of the railcar 10 is turned on (S10), the arrester monitor 20 is powered on (S11). Consequently, the arrester monitor 20 determines whether or not the arrester 16 is in a healthy state (S12). In a case where the arrester 16 is determined to be in a healthy state, a pantograph-raising permission is given (S13). In this manner, the permission to raise the pantograph 11 is given for the arrester 16. Then, the pantograph 11 is pressed against the overhead contact line, and a breaker-closing permission is given (S14). Thereafter, it is determined whether or not a current entering the current transformer 14 is an overcurrent (S15). In a case where the current entering the current transformer 14 is not an overcurrent, the flow ends. In a case where the current entering the current transformer 14 is an overcurrent, the breaker 15 is opened (S20), and the flow ends. After the breaker 15 is opened, the breaker 15 is brought into a closing-prohibited state, and then even if an operation to close the breaker 15 is erroneously performed, the breaker 15 will not be closed.

On the other hand, in a case where it is determined in the above determination step (S12) that the arrester 16 is not in a healthy state, it is determined whether or not the arrester 16 is in a warning state (S16). In a case where the arrester 16 is determined to be in a warning state, a signal to display "WARNING" is outputted to the display 30 (S17). Further, it is determined whether or not immediate replacement of the arrester 16 is possible (S18). In a case where the immediate replacement is impossible, the above-described pantograph-raising permission is given (S13), and also a permission to close the breaker 15 is given (S14). Then, it is determined whether or not a current entering the current transformer 14 is an overcurrent

(S15). In a case where the current entering the current transformer 14 is not an overcurrent, the flow ends. In a case where the current entering the current transformer 14 is an overcurrent, the breaker 15 is opened (S20), and the flow ends. After the breaker 15 is opened, the breaker 15 is brought into a closing-prohibited state, and then even if an operation to close the breaker 15 is erroneously performed, the breaker 15 will not be closed.

In a case where it is determined in the above determination step (S18) that the immediate replacement is possible, a signal to prohibit pantograph raising is outputted (S19), and the breaker 15 is opened (S20). Then, the flow ends. The signal to prohibit pantograph raising includes a signal to disconnect pantograph-raising control circuitry that is included in the control circuitry 27 of the railcar 10. Further, opening the breaker 15 includes outputting a signal to interrupt breaker-closing control circuitry that is included in the control circuitry 27 of the railcar 10. After the signal to prohibit pantograph raising is outputted, even if an operation to raise the pantograph 11 is performed erroneously, the pantograph 11 will not be raised. Also, after the breaker 15 is opened, the breaker 15 is brought into a closing-prohibited state, and then even if an operation to close the breaker 15 is erroneously performed, the breaker 15 will not be closed.

In a case where it is determined in the above determination step (S 16) that the arrester 16 is not in a warning state, a signal to display "FAILURE" is outputted to the display 30 (S21). Thereafter, a signal to prohibit pantograph raising is outputted (S19), and the breaker 15 is opened (S20). Then, the flow ends. After the signal to prohibit pantograph raising is outputted, even if an operation to raise the pantograph 11 is performed erroneously, the pantograph 11 will not be raised. Also, after the breaker 15 is opened, the breaker 15 is brought into a closing-prohibited state, and then even if an operation to close the breaker 15 is erroneously performed, the breaker 15 will not be closed.

As described above, at the time of powering on the railcar 10, the arrester monitor 20 determines whether or not the arrester 16 is in a state of deterioration, and in a case where the arrester 16 is in a state of deterioration, a "warning" or "failure" alarm is raised, which makes early-stage replacement of the arrester 16 possible.

### (Flowchart at the time of powering off the railcar)

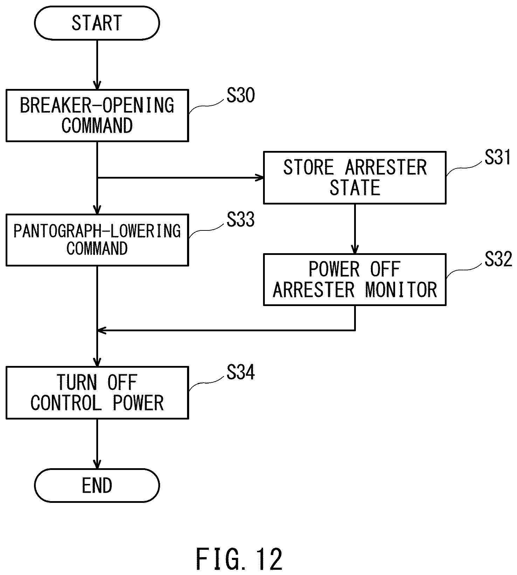

FIG. 12 is a third flowchart showing a flow of operations of the arrester monitor 20 at the time of powering off the railcar 10. Also in the third flowchart, a flow of operations of the railcar 10 is shown on the left side, and the flow of operations of the arrester monitor 20 is shown on the right side.

At the time of powering off the railcar 10, the flow starts, and an opening command is given to the breaker 15 (S30). In response to the command signal, the arrester monitor 20 performs arrester state storing to store the state of the arrester 16 before the powering off (S31). The arrester state storing may be, for example, as shown in FIG. 7, storing the average value Ix within the predetermined time from the time x₁ to the time x₂ as a leakage current average value Ix(x₂) at the time of powering off. Thereafter, the arrester monitor 20 is powered off (S32). Also, a command to lower the pantograph 11 is given to the railcar 10 (S33), and the control power of the railcar 10 is turned off (S34). Then, the flow ends.

The arrester state storing by the arrester monitor 20 at the time of powering off the railcar 10 is the storing of the leakage current at the time x₂ when powering off. Therefore, the final leakage current average value Ix(x₂) when powering off the arrester 16 at the time of powering off the railcar 10 can be used as a basis for the determination in step (S12) shown in FIG. 11.

The state of deterioration of the arrester 16 may be determined and an alarm may be raised at the time of powering off the arrester monitor 20. In a case where an alarm is raised at the time of ending the operation of the railcar 10, and the alarm indicates that it is necessary to replace the arrester 16, the arrester 16 can be replaced before the start of the next operation of the railcar 10. In a case where an alarm is raised before the start of operating the railcar 10, the state of the arrester 16 can be checked based on the alarm before the start of operating the railcar 10. The alarm can be displayed as a message. For example, the displayed message may be: "The arrester is in a state of deterioration. Please replace the arrester at the next inspection of the railcar." As another example, the displayed message may be: "The arrester is in a state of failure. Please replace the arrester." The alarm may be raised with use of light.

### (Example of raising an alarm by the arrester monitor)

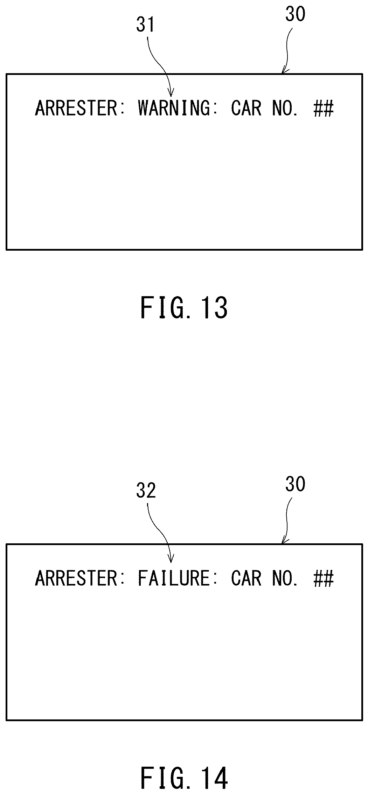

FIG. 13 illustrates a display example of "WARNING" on a display monitor screen as shown in FIG. 10 and FIG. 11. FIG. 14 illustrates a display example of "FAILURE" on the display monitor screen as shown in FIG. 10 and FIG. 11. The present embodiment describes examples in which the state of deterioration of the arrester 16 is notified on the display monitor.

As shown in FIG. 13, in the case of a "WARNING" display 31 on the display 30 in the "WARNING" displaying step (S4) of FIG. 10 and the "WARNING" displaying step (S17) of FIG. 11, for example, a message "ARRESTER: WARNING: CAR NO. ##" is displayed on the display 30, which can be checked at the driver's seat of the railcar 10. In this manner, information indicating on which car the arrester 16 is in a state of deterioration can be displayed. For example, the display can be shown in yellow to draw attention.

Further, as shown in FIG. 14, in the case of a "FAILURE" display 32 on the display 30 in the "FAILURE" displaying step (S7) of FIG. 10 and the "FAILURE" displaying step (S21) of FIG. 11, for example, a message "ARRESTER: FAILURE: CAR NO. ##" is displayed on the display 30, which can be checked at the driver's seat of the railcar 10. In this manner, information indicating on which car the arrester 16 is in a state of failure can be displayed. For example, the display can be shown in red to draw more attention.

In the present embodiment, an alarm is raised by using the display 30, which is, for example, a display monitor of the railcar. Alternatively, an alarm can be raised by, for example, a sound or a warning lamp. These different alarm raising methods may be combined, and the alarm raising method is not limited to those described in the present embodiment.

In a case where an alarm is raised at the end of the operation of the railcar 10, and the alarm indicates that it is necessary to replace the arrester 16, the arrester 16 can be replaced before the start of the next operation of the railcar 10. In a case where an alarm is raised before the start of operating the railcar 10, the state of the arrester 16 can be checked based on the alarm before the start of operating the railcar 10. The alarm can be displayed as a message. For example, the displayed message may be: "The arrester is in a state of deterioration. Please replace the arrester at the next inspection of the railcar." As another example, the displayed message may be: "The arrester is in a state of failure. Please replace the arrester."

### (Other Variations)

The above embodiment has described examples in which the railcar 10 includes eight cars. However, the number of cars included in the railcar 10, the number of pantographs 11, etc., are not limited to those described in the above embodiment.

Configurations, combinations, etc., described in the above embodiment are merely examples, and additions, omissions, replacements, and other modifications can be suitably made to the described configurations without departing from the scope of the present disclosure. The present disclosure is not limited to the embodiment, but is defined by the claims.

The functionality of the elements disclosed herein may be implemented using circuitry or processing circuitry which includes general purpose processors, special purpose processors, integrated circuits, ASICs ("Application Specific Integrated Circuits"), conventional circuitry and/or combinations thereof which are configured or programmed to perform the disclosed functionality. Processors are considered processing circuitry or circuitry as they include transistors and other circuitry therein. In the disclosure, the circuitry, units, or means are hardware that carry out or are programmed to perform the recited functionality. The hardware may be any hardware disclosed herein or otherwise known which is programmed or configured to carry out the recited functionality. When the hardware is a processor which may be considered a type of circuitry, the circuitry, means, or units are a combination of hardware and software, the software being used to configure the hardware and/or processor.

As described above, according to the above-described arrester monitor 20, the value of a current that flows from the arrester 16 to the carbody 19 via the electrical path 18 is measured by the galvanometer 21, and the measured value of the current can be stored in the data storage 22 as history data in a chronological manner. Based on a chronological change in the history data stored in the data storage 22, the processing circuitry 23 determines that the arrester 16 is in a state of deterioration and outputs a predetermined deterioration signal in a case where an average value of the current within a predetermined unit time is greater than a predetermined deterioration threshold value. Accordingly, the fact that the arrester of the railcar 10 is in a state of deterioration can be known from the deterioration signal.

The processing circuitry may determine that the arrester is in the state of deterioration in a case where, in the history data, a number of occurrences of a current value change pattern is greater than a predetermined number of times, the current value change pattern being a pattern in which the value of the current exceeds a predetermined overcurrent threshold value and then drops below the overcurrent threshold value. With this configuration, a determination that the arrester is in a state of deterioration can be made based on the fact that the number of occurrences of the current value change pattern, in which the value of the current that flows from the arrester to the carbody exceeds the predetermined overcurrent threshold value and then drops below the overcurrent threshold value, is greater than the predetermined number of times.

The deterioration signal may include a signal to display a warning on a display. According to this configuration, the state of deterioration of the arrester can be displayed on the display for external notification purposes.

The deterioration signal may include a signal to open a breaker that is interposed in a power feeding path to the arrester. According to this configuration, the breaker can be opened in accordance with the state of deterioration of the arrester to prevent a current from flowing to the arrester.

The deterioration signal may include a signal to prohibit raising of a pantograph of the railcar. According to this configuration, pantograph raising can be prohibited in accordance with the state of deterioration of the arrester to prevent entry of a current from the overhead contact line.

The state of deterioration may be divided into multiple deterioration levels corresponding to respective deterioration degrees of the arrester, and the processing circuitry may make the deterioration signal different in accordance with to which one of the multiple deterioration levels the chronological change in the history data corresponds. According to this configuration, for example, a replacement work timing for the arrester can be planned in accordance with the deterioration signal, which is different for each deterioration level of the arrester.

A railcar including the arrester monitor according to any one of the above-described modes is capable of properly determining, with the arrester monitor, that an arrester included in the railcar is in a state of deterioration.

### Reference Signs List

- 10: railcar
- 11: pantograph
- 12: wheel
- 13: power feeding path
- 14: current transformer
- 15: breaker
- 16: arrester
- 17: electrical path
- 18: electrical path
- 19: carbody
- 20: arrester monitor
- 21: galvanometer
- 22: data storage
- 23: processing circuitry
- 24: determiner
- 25: first output circuitry
- 26: second output circuitry
- 30: display
- 100: overhead contact line
- 110: rail

## Claims

1. An arrester monitor comprising:
a galvanometer that measures, on an electrical path between an arrester of a railcar and a carbody of the railcar, a value of a current that flows from the arrester to the carbody;
a data storage that stores the value of the current, which has been measured by the galvanometer, as history data in a chronological manner; and
processing circuitry configured to determine, based on a chronological change in the history data stored in the data storage, that the arrester is in a state of deterioration and output a predetermined deterioration signal in a case where an average value of the current within a predetermined unit time is greater than a predetermined deterioration threshold value.

2. The arrester monitor according to claim 1, wherein
the processing circuitry determines that the arrester is in the state of deterioration in a case where, in the history data, a number of occurrences of a current value change pattern is greater than a predetermined number of times, the current value change pattern being a pattern in which the value of the current exceeds a predetermined overcurrent threshold value and then drops below the overcurrent threshold value.

3. The arrester monitor according to claim 1 or 2, wherein
the deterioration signal includes a signal to display a warning on a display.

4. The arrester monitor according to any one of claims 1 to 3, wherein
the deterioration signal includes a signal to open a breaker that is interposed in a power feeding path to the arrester.

5. The arrester monitor according to any one of claims 1 to 4, wherein
the deterioration signal includes a signal to prohibit raising of a pantograph of the railcar.

6. The arrester monitor according to any one of claims 1 to 5, wherein
the state of deterioration is divided into multiple deterioration levels corresponding to respective deterioration degrees of the arrester, and
the processing circuitry makes the deterioration signal different in accordance with to which one of the multiple deterioration levels the chronological change in the history data corresponds.

7. A railcar comprising the arrester monitor according to any one of claims 1 to 6.
